# EUROPÄISCHE PATENTSCHRIFT

(11) **EP 4 154 023 B1**
(45) Veröffentlichungstag und Bekanntmachung des Hinweises auf die Patenterteilung: **15.11.2023**
(21) Anmeldenummer: 22744194.6
(22) Anmeldetag: 14.07.2022
(51) Int. Cl.: G01R 19/10, G01R 31/52, G01R 23/18

(54) **DIFFERENZSTROMSENSOR, ANALYSEVERFAHREN UND VERWENDUNG EINES DIFFERENZSTROMSENSORS**
DIFFERENTIAL CURRENT SENSOR, ANALYSIS METHOD, AND USE OF A DIFFERENTIAL CURRENT SENSOR
CAPTEUR DE COURANT DIFFÉRENTIEL, PROCÉDÉ D'ANALYSE, ET UTILISATION D'UN CAPTEUR DE COURANT DIFFÉRENTIEL

(30) Priorität: 30.07.2021 DE 102021119877
(43) Veröffentlichungstag der Anmeldung: 29.03.2023
(73) Patentinhaber: Magnetec GmbH, 63505 Langenselbold (DE)
(72) Erfinder: Wentzlik, Thomas, 60385 Frankfurt (DE)
(74) Vertreter: Richly & Ritschel Patentanwälte PartG mbB
(86) Internationale Anmeldenummer: PCT/EP2022/069742
(87) Internationale Veröffentlichungsnummer: WO 2023/006439

(56) Entgegenhaltungen:
- EP-A1- 3 757 580
- CN-A- 112 731 220
- US-A1- 2017 176 567
- US-A1- 2019 178 916

## Beschreibung

Die Erfindung betrifft einen Differenzstromsensor, ein Analyseverfahren und die Verwendung eines Differenzstromsensors.

Differenzstromsensoren zur Bestimmung von Differenzströmen sind in unterschiedlichen Bauformen und für unterschiedliche Applikationsfälle bekannt, insbesondere da Differenzströme für Personen eine Gefahr darstellen und Brände auslösen können. Differenzströme treten auf, wenn ein elektrisches Versorgungsnetz, insbesondere ein Stromkreis innerhalb eines elektrischen Versorgungsnetzes, einen Defekt aufweist und dadurch innerhalb des elektrischen Versorgungsnetzes ein Fehlerstrom gegen Erde abfließen kann. Je nach Art und Aufbau des elektrischen Versorgungsnetzes können Differenzströme Wechselstromkomponenten und/oder Gleichstromkomponenten aufweisen. Einige bekannte Differenzstromsensoren sind in US 2019/178916 A1, EP 3 757 580 A1 und US 2017/176567 A1 zu sehen.

Ein allstromsensitiver Differenzstromsensor überwacht gleichzeitig alle Ströme, die in den Phasen und dem Neutralleiter fließen und detektiert mögliche Gleich- und Wechselstromfehler.

Für den Betrieb eines allstromsensitiven Differenzstromsensors sind Analysevorrichtungen bekannt, welche einen Oszillator verwenden um das magnetfeldempfindliche Bauelement wechselseitig in den Zustand einer Sättigung des magnetfeldempfindlichen Bauelements zu bringen, insbesondere einen Royer Oszillator.

Der Erfindung liegt die Aufgabe zugrunde, dem Stand der Technik eine Verbesserung oder eine Alternative zur Verfügung zu stellen.

Die Erfindung wird durch den Differenzstromsensor gemäß Anspruch 1, durch das Analyseverfahren gemäß Anspruch 9 und durch die Verwendung eines Differenzstromsensors gemäß Anspruch 13 definiert. Weitere Aspekte werden durch die entsprechenden abhängigen Ansprüche definiert.

### Begrifflich sei hierzu Folgendes erläutert:

Zunächst sei ausdrücklich darauf hingewiesen, dass im Rahmen der hier vorliegenden Patentanmeldung unbestimmte Artikel und Zahlenangaben wie "ein", "zwei" usw. im Regelfall als "mindestens"-Angaben zu verstehen sein sollen, also als "mindestens ein...", "mindestens zwei ..." usw., sofern sich nicht aus dem jeweiligen Kontext ausdrücklich ergibt oder es für den Fachmann offensichtlich oder technisch zwingend ist, dass dort nur "genau ein ...", "genau zwei ..." usw. gemeint sein können.

Im Rahmen der hier vorliegenden Patentanmeldung sei der Ausdruck "insbesondere" immer so zu verstehen, dass mit diesem Ausdruck ein optionales, bevorzugtes Merkmal eingeleitet wird. Der Ausdruck ist nicht als "und zwar" und nicht als "nämlich" zu verstehen.

Unter einer "Stromaufnahme" wird die Stromstärke verstanden, welche bei einer definierten Spannung durch den Stromkreis fließt, insbesondere durch die Testwicklung und/oder die erste Hauptwicklung und/oder eine zweite Hauptwicklung. Ausdrücklich sei darauf hingewiesen, dass die Begrifflichkeit Stromaufnahme keine Aussage über das Vorzeichen des Stromes erfordert. Insbesondere kann eine Stromaufnahme einem positivem oder einem negativen Strom entsprechen.

Vorzugsweise wird unter dem Sensorsignal die Stromaufnahme der ersten Hauptwicklung verstanden. Vorzugsweise kann die Stromaufnahme der ersten Hauptwicklung mittels einer mathematischen Vorschrift in den einen Differenzstrom des von dem Sensor designiert überwachten Stromkreises überführt werden. Vorzugsweise kann diese mathematische Vorschrift durch eine Kalibrationskurve des Sensors bestimmt werden.

Alternativ wird unter dem an der Hauptwicklung messbaren Signal die Stromaufnahme der ersten Hauptwicklung verstanden. Vorzugsweise kann die Stromaufnahme der ersten Hauptwicklung mittels einer mathematischen Vorschrift in den einen Differenzstrom des von dem Sensor designiert überwachten Stromkreises überführt werden. Vorzugsweise kann diese mathematische Vorschrift durch eine Kalibrationskurve des Sensors bestimmt werden. Alternativ oder zusätzlich kann diese mathematische Vorschrift durch die Materialeigenschaften des magnetfeldempfindlichen Bauelements bestimmt werden.

Ein an der Hauptwicklung messbares Signal kann auch als Sensorsignal bezeichnet werden, insbesondere ein an der ersten Hauptwicklung und/oder an der zweiten Hauptwicklung messbares Signal. Dabei sei unter anderem daran gedacht, dass die erste Hauptwicklung aktiv mit dem Signal eines Oszillators bestromt wird, insbesondere mit dem Signal eines Royer Oszillators.

Unter einem "elektrischen Differenzstrom" wird die vektorielle Summe der Ströme aller elektrischen Leiter verstanden, um welche der Sensor herum angeordnet ist.

Ein elektrischer Differenzstrom kann eine Wechselstromkomponente und/oder eine Gleichstromkomponente aufweisen. Insbesondere kann ein elektrischer Differenzstrom eine pulsierende Gleichstromkomponente und/oder eine glatte Gleichstromkomponente aufweisen. Ein elektrischer Differenzstrom kann auch als Fehlerstrom bezeichnet werden.

Unter einem "allstromsensitiven Bestimmen" eines Differenzstroms wird verstanden, dass der Sensor dazu eingerichtet ist, sowohl eine Wechselstromkomponente als auch eine Gleichstromkomponente bestimmen zu können. Insbesondere wird unter einem allstromsensitiven Bestimmen eines Differenzstroms verstanden, dass der Sensor dazu eingerichtet ist, sowohl eine pulsierende Gleichstromkomponente als auch eine glatte Gleichstromkomponente bestimmen zu können.

Unter einem "magnetfeldempfindlichen Bauelement" wird ein Bauelement verstanden, welches auf ein Magnetfeld mit der Veränderung zumindest einer Zustandsgröße des Bauelements reagiert.

Vorzugsweise wird unter einem magnetfeldempfindlichen Bauelement ein Stoff verstanden, welcher magnetische Eigenschaften aufweist.

Besonders vorzugsweise wird unter einem magnetfeldempfindlichen Bauelement ein weichmagnetischer Stoff verstanden.

Unter einem "weichmagnetischen Stoff" wird ein Stoff verstanden, welcher sich in einem Magnetfeld leicht magnetisieren lässt. Vorzugsweise weist ein weichmagnetischer Stoff eine Koerzitivfeldstärke von weniger gleich 1.000 A/m auf.

Ein weichmagnetischer Stoff kann eine Koerzitivfeldstärke von kleiner oder gleich 800 A/m aufweisen, vorzugsweise eine Koerzitivfeldstärke von kleiner oder gleich 500 A/m bevorzugt eine Koerzitivfeldstärke von kleiner oder gleich 100 A/m und besonders bevorzugt eine Koerzitivfeldstärke von kleiner oder gleich 50 A/m.

Unter der "Koerzitivfeldstärke" wird die magnetische Feldstärke verstanden, die notwendig ist, um ein zuvor bis zur Sättigungsflussdichte aufgeladenes magnetfeldempfindliches Bauelement vollständig zu entmagnetisieren.

Vorzugsweise wird unter einem weichmagnetischen Stoff ein Stoff verstanden, welcher aus einem amorphen Metall hergestellt worden ist und eine nanokristalline Struktur aufweist.

Insbesondere weist ein weichmagnetischer Stoff eine Legierung aufweisend Eisen, Nickel und Cobalt auf.

Unter einer "Wicklung" wird eine um ein magnetfeldempfindliches Bauelement verlaufende Aufwicklung eines elektrisch leitfähigen Materials im festen Aggregatzustand verstanden, insbesondere in Form eines Drahtes.

Alternativ kann eine Wicklung als eine um ein magnetfeldempfindliches Bauelement verlaufende elektrisch leitfähige Verbindung aus zwei oder mehr elektrisch leitfähigen Materialien im festen Aggregatzustand ausgebildet sein. Insbesondere kann eine Wicklung als eine um ein magnetfeldempfindliches Bauelement verlaufende elektrisch leitfähige Verbindung aus einem elektrisch leitfähigen Leiterstück und einer mit dem elektrisch leitfähigen Leiterstück elektrisch verbundenen Platine gebildet sein. Das elektrisch leitfähige Leiterstück kann dabei das magnetfeldempfindliche Bauelement weniger als vollständig umschließen.

Unter einer "Hauptwicklung" wird eine Wicklung verstanden, die dazu eingerichtet ist, aktiv mittels einer Stromquelle mit einem elektrischen Strom versorgt zu werden. Alternativ kann eine Hauptwicklung auch mit einer Spannungsquelle verbunden sein. Eine Hauptwicklung kann auch als "erste Hauptwicklung" bezeichnet werden. Alternativ oder zusätzlich kann eine Hauptwicklung auch als "zweite Hauptwicklung" bezeichnet werden.

Vorzugsweise ist eine Hauptwicklung, insbesondere eine erste Hauptwicklung, dazu eingerichtet, ein Sensorsignal bereitzustellen, insbesondere mittelbar durch die Stromaufnahme der Hauptwicklung, insbesondere mittelbar durch die Stromaufnahme der ersten Hauptwicklung und/oder der zweiten Hauptwicklung.

Alternativ oder zusätzlich ist eine Hauptwicklung, insbesondere eine erste Hauptwicklung und/oder eine zweite Hauptwicklung, dazu eingerichtet, ein an der ersten Hauptwicklung und/oder an der zweiten Hauptwicklung messbares Signal bereitzustellen, insbesondere mittelbar durch die Stromaufnahme der Hauptwicklung, insbesondere mittelbar durch die Stromaufnahme der ersten Hauptwicklung und/oder der zweiten Hauptwicklung.

Vorzugsweise kann aus der Stromaufnahme der Hauptwicklung, insbesondere der ersten und/oder einer zweiten Hauptwicklung, mittels einer mathematischen Vorschrift der Differenzstrom des designiert mit dem Sensor überwachten Stromkreises bestimmt werden, vorzugsweise mittels einer mathematischen Vorschrift, welche aus einer Kalibration des Sensors abgeleitet werden kann.

Alternativ oder zusätzlich kann aus der Stromaufnahme der Hauptwicklung, insbesondere der ersten und/oder einer zweiten Hauptwicklung, mittels einer mathematischen Vorschrift der Differenzstrom des designiert mit dem Sensor überwachten Stromkreises bestimmt werden, vorzugsweise mittels einer mathematischen Vorschrift, welche aus einer Kalibration des Sensors abgeleitet werden kann und besonders bevorzugt welche aus einer Kalibration des Sensors und/oder der Materialeigenschaften des magnetfeldempfindlichen Bauelements abgeleitet werden kann.

Eine besonders bevorzugte Ausführungsform weist eine erste Hauptwicklung und eine zweite Hauptwicklung auf. Die erste Hauptwicklung kann dazu eingerichtet sein, aktiv mittels einer Stromquelle mit einem elektrischen Strom versorgt zu werden, insbesondere von einem Oszillator, bevorzugt von einem Royer Oszillator. Alternativ kann die erste Hauptwicklung auch mit einer Spannungsquelle verbunden sein. Die zweite Hauptwicklung kann dazu eingerichtet sein, ein an der zweiten Hauptwicklung messbares Signal bereitzustellen, insbesondere mittelbar durch die Stromaufnahme der zweiten Hauptwicklung.

Unter einem "Zustandsanalysemittel" wird jedes Mittel verstanden, dass dazu geeignet ist, eine mathematische Vorschrift und/oder eine Abfolge mathematischer Vorschriften zur Bestimmung und/oder Analyse eines Zustands auszuführen. Insbesondere wird unter einem Zustandsanalysemittel eine elektronische Steuereinheit verstanden, vorzugsweise ein Prozessor und/oder ein Mikrocontroller.

Unter einem "Zustand" des Differenzstromsensors können unter anderem folgende Zustände verstanden werden:
- An den von dem Differenzstromsensor überwachten Leitern tritt kein Fehlerstrom auf;
- An den von dem Differenzstromsensor überwachten Leitern tritt ein Fehlerstrom von kleiner oder gleich 10 mA auf;
- An den von dem Differenzstromsensor überwachten Leitern tritt ein Fehlerstrom von größer als 10 mA auf;
- Das magnetfeldempfindliche Bauelement weist einen magnetischen Offset auf; und
- Dem Nutzsignal des Sensors ist ein Fehlerstrom überlagert.

Unter einem Zustand eines Differenzstromsensors können weiterhin einer oder mehrere der nachfolgenden Zustände verstanden werden:
- An den von dem Differenzstromsensor überwachten Leitern tritt ein Fehlerstrom auf;
- An den von dem Differenzstromsensor überwachten Leitern tritt ein Fehlerstrom, insbesondere ein Wechselfehlerstrom, von kleiner oder gleich 35 mA auf, vorzugsweise ein Fehlerstrom von kleiner oder gleich 20 mA und besonders bevorzugt ein Fehlerstrom von kleiner oder gleich 12 mA;
- An den von dem Differenzstromsensor überwachten Leitern tritt ein Fehlerstrom, insbesondere ein Wechselfehlerstrom, von größer oder gleich 6 mA auf, vorzugsweise ein Fehlerstrom von größer oder gleich 15 mA und besonders bevorzugt ein Fehlerstrom von größer oder gleich 30 mA;

- An den von dem Differenzstromsensor überwachten Leitern tritt ein Gleichfehlerstrom, insbesondere ein Wechselfehlerstrom, von kleiner oder gleich 6 mA auf, vorzugsweise ein Fehlerstrom von kleiner oder gleich 5 mA und besonders bevorzugt ein Fehlerstrom von kleiner oder gleich 4 mA;
- An den von dem Differenzstromsensor überwachten Leitern tritt ein Gleichfehlerstrom, insbesondere ein Wechselfehlerstrom, von größer oder gleich 2 mA auf, vorzugsweise ein Fehlerstrom von größer oder gleich 3 mA und besonders bevorzugt ein Fehlerstrom von größer oder gleich 4 mA;
- Das magnetfeldempfindliche Bauelement weist einen magnetischen Offset von größer oder gleich 2 % der Sättigungsflussdichte des magnetfeldempfindlichen Bauelements auf; vorzugsweise von größer oder gleich 5 % der Sättigungsflussdichte des magnetfeldempfindlichen Bauelements und besonders bevorzugt von größer oder gleich 8 % der Sättigungsflussdichte des magnetfeldempfindlichen Bauelements;
- An den von dem Differenzstromsensor überwachten Leitern fließt kein Strom; und
- An den von dem Differenzstromsensor überwachten Leitern fließt ein Strom.

Bekannte Analysevorrichtungen können nicht eindeutig zwischen unterschiedlichen Zuständen differenzieren, insbesondere kann ein Fehlerstrom nicht von einer Magnetisierung des Kerns unterschieden werden.

Unter anderem wird hier vorgeschlagen, dass das Signal eines Differenzstromsensors in ein Frequenzspektrum überführt wird und anhand des Frequenzspektrums ein Zustand des Differenzstromsensors bestimmt wird. Es hat sich gezeigt, dass anhand einer Analyse eines Frequenzspektrums eindeutig zwischen den unterschiedlichen Zuständen differenziert werden kann, insbesondere kann ein vormagnetisierter Kern von einem Fehlerstrom differenziert werden.

Ein Frequenzspektrum enthält durch seine komplexe Darstellung bei der die Amplitude des Signals in Abhängigkeit von der Frequenz vorliegt, kann im Unterschied zu der bislang bekannten eindimensionalen Auswertung von Sensorsignalen mehrdimensional ausgewertet werden. Hierdurch kann zumindest ein zusätzlicher Indikator für die Auswertung des Sensorsignals zu Analyse herangezogen werden. Vorteilhaft kann hierdurch erreicht werden, dann neben dem Vorliegen eines Differenzstroms parallel auch der Zustand des Kerns bewertet werden kann. Weiterhin kann bevorzugt erreicht werden, dass unterschiedliche Zustände eindeutig voneinander differenziert werden können.

Ein Frequenzspektrum enthält durch seine komplexe Darstellung bei der die Amplitude des Signals in Abhängigkeit von der Frequenz vorliegt, einen höheren Informationsgehalt als konventionelle Signale, insbesondere als zeitaufgelöste Signale. Dadurch kann im Unterschied zu der bislang bekannten eindimensionalen Auswertung von Sensorsignalen mehrdimensional ausgewertet werden, insbesondere in der Dimension Frequenz und/oder Dimension einer Amplitude des Frequenzdichtespektrums. Hierdurch kann zumindest ein zusätzlicher Indikator für die Auswertung des Sensorsignals zu Analyse herangezogen werden. Vorteilhaft kann hierdurch erreicht werden, dass neben dem Vorliegen eines Differenzstroms parallel auch der Zustand des Kerns bewertet werden kann. Weiterhin kann bevorzugt erreicht werden, dass unterschiedliche Zustände eindeutig voneinander differenziert werden können. Insbesondere kann dadurch erreicht werden, dass wenn mehr als ein Zustand gleichzeitig vorliegt, die vorliegenden Zustände besser voneinander differenziert werden können, insbesondere trennschärfer voneinander differenziert werden können.

Es hat sich insbesondere gezeigt, dass über eine Frequenzänderung und eine Amplitudenänderung sehr schnell und zuverlässig ein übergroßer Fehlerstrom erkannt werden kann.

Ferner hat sich insbesondere gezeigt, dass über die Änderung der Anzahl der Frequenzen eines Frequenzspektrums des Signals sehr schnell und zuverlässig ein Fehlerstrom erkannt werden kann, insbesondere eine Gleichstromkomponente des Fehlerstroms und/oder eine Wechselstromkomponente des Fehlerstroms und bevorzugt eine glatte Gleichstromkomponente des Fehlerstroms.

Wiederum hat sich insbesondere gezeigt, dass über die Änderung der Amplitude zumindest einer Harmonischen eines Frequenzspektrums des Signals sehr schnell und zuverlässig ein Fehlerstrom erkannt werden kann, insbesondere eine Gleichstromkomponente des Fehlerstroms und/oder eine Wechselstromkomponente des Fehlerstroms und bevorzugt eine glatte Gleichstromkomponente des Fehlerstroms.

Besonders vorteilhaft hat sich gezeigt, dass über die Änderung der Anzahl der Frequenzen und die Änderung der Amplitude zumindest einer Harmonischen eines Frequenzspektrums des Signals besonders schnell und zuverlässig ein Fehlerstrom erkannt werden kann, insbesondere eine Gleichstromkomponente des Fehlerstroms und/oder eine Wechselstromkomponente des Fehlerstroms und bevorzugt eine glatte Gleichstromkomponente des Fehlerstroms.

Zweckmäßig weist die Analysevorrichtung einen Differenzverstärker auf.

Bevorzugt weist der Differenzverstärker eine Bandbreite von größer oder gleich 10 MHz auf.

Gemäß einer besonders vorteilhaften Ausführungsform weist die Analysevorrichtung einen Analog-Digital-Wandler auf.

Zweckmäßig weist der Analog-Digital-Wandler einen Signal-Rauschabstand unter dem Nutzsignal auf. Weiterhin bevorzugt weist der Analog-Digital-Wandler eine Auflösung von kleiner oder gleich 100µV/bit auf.

Hierdurch kann für einige Ausführungsformen vorteilhaft eine analoge Umwandlung des gemessenen Signals in einen Frequenzbereich umgangen werden. Digitale Verfahren weisen einen geringeren Aufwand auf und benötigen weniger Zeit für die Analyse.

Die Analysevorrichtung kann einen Prozessor aufweisen, insbesondere einen Mikrocontroller. Zweckmäßig weist die Analysevorrichtung einen Prozessor auf, insbesondere einen Mikrocontroller, insbesondere ein FPGA (Field Programmable Gate Array).

Vorteilhaft kann so die Analyse des Signals mittels dem Prozessor, insbesondere mittels dem Mikrocontroller erfolgen.

Ein Mittel zur Bestimmung eines an der Hauptwicklung messbaren Signals kann zumindest einen Analog-Digital-Wandler aufweisen und/oder zumindest einen Differenzverstärker und/oder zumindest einen Prozessor und/oder zumindest einen Mikrocontroller.

Zweckmäßig kann das Zustandsanalysemittel zur Bestimmung des Zustands dazu eingerichtet sein,
- zumindest einen Analysewert aus dem Frequenzspektrum des Signals zu bestimmen;
- den Analysewert mit zumindest einem korrespondierenden Fehlerschwellwert zu vergleichen; und
- zumindest einen Zustand in Abhängigkeit des Vergleichs von dem Analysewert mit dem korrespondierenden Fehlerschwellwert zu bestimmen, insbesondere zumindest zwei, drei, vier oder mehr Zustände.

### Begrifflich sei hierzu zunächst folgendes erläutert:

Unter einem "Analysewert" kann jeder beliebige Wert der aus dem Frequenzspektrum des Signals bestimmt werden kann verstanden werden.

Der Analysewert kann als skalarer Wert ausgebildet sein. Alternativ oder zusätzlich kann der Analysewert als vektorieller Wert ausgebildet sein. Mit anderen Worten kann der Analysewert mehr als eine Größe umfassen. Insbesondere kann der Analysewert zwei, drei oder mehr Werte umfassen.

Insbesondere kann der Analysewert einer Amplitude zumindest einer Harmonischen des Frequenzspektrums des Signals entsprechen, bevorzugt zumindest den Amplituden zwei Harmonischer und besonders bevorzugt den Amplituden zumindest drei Harmonischer.

Unter einer "Amplitude" kann die maximale Auslenkung einer harmonischen Schwingung aus der Lage des arithmetischen Mittels verstanden werden. Insbesondere kann unter einer Amplitude die maximale Auslenkung einer Harmonischen verstanden werden. In einem Frequenzspektrum eines Signals kann jeder Harmonischen des Signals eine Amplitude zugeordnet sein.

Der Analysewert kann dazu geeignet sein, mit zumindest einem korrespondierenden Fehlerschwellwert verglichen zu werden um zumindest einen Zustand, insbesondere zwei, drei, vier oder mehr Zustände des designierten Differenzstromsensors zu bestimmen. Vorteilhaft kann der Analysewert einem Quadrat einer Amplitude zumindest einer Harmonischen des Frequenzspektrums des Signals entsprechen, bevorzugt als Quadrate von Amplituden zumindest zwei Harmonischer und besonders bevorzugt als Quadrate von Amplituden zumindest drei Harmonischer.

Vorteilhaft kann der Analysewert einer Summe von Amplituden von zumindest zwei Harmonischen des Frequenzspektrums des Signals entsprechen, bevorzugt einer Summe von Amplituden von zumindest drei Harmonischen des Frequenzspektrums des Signals und besonders bevorzugt einer Summe von Amplituden von zumindest vier oder mehr Harmonischen des Frequenzspektrums des Signals.

Vorteilhaft kann der Analysewert einer Summe von Quadraten von Amplituden von zumindest zwei Harmonischen des Frequenzspektrums des Signals entsprechen, bevorzugt einer Summe von Quadraten von Amplituden von zumindest drei Harmonischen des Frequenzspektrums des Signals und besonders bevorzugt einer Summe von Quadraten von Amplituden von zumindest vier oder mehr Harmonischen des Frequenzspektrums des Signals.

Unter einem "korrespondierenden Fehlerschwellwert" ist jeder beliebige Wert zu verstehen, der dazu geeignet ist, mit zumindest einem Analysewert verglichen zu werden. Ein Fehlerschwellwert kann in einen zugehörigen Fehlerstrom überführt werden, insbesondere in eine Stromaufnahme die an einer ersten Hauptwicklung und/oder an einer zweiten Hauptwicklung gemessen werden kann.

Der korrespondierende Fehlerschwellwert kann als skalarer Wert ausgebildet sein. Alternativ oder zusätzlich kann der korrespondierende Fehlerschwellwert als vektorieller Wert ausgebildet sein. Mit anderen Worten kann der korrespondierende Fehlerschwellwert mehr als eine Größe umfassen. Insbesondere kann der korrespondierende Fehlerschwellwert zwei, drei oder mehr Werte umfassen.

Insbesondere kann zumindest ein Analysewert mit zumindest einem Fehlerschwellwert korrespondieren. Mit anderen Worten kann einem Fehlerschwellwert zumindest ein Analysewert zugeordnet werden.

Ein Fehlerschwellwert kann durch eine Berechnung und/oder Simulation eines Bauteilverhaltens eines magnetfeldempfindlichen Bauelements ermittelt werden. Insbesondere kann ein Fehlerschwellwert abhängig von Materialeigenschaften eines magnetfeldempfindlichen Bauelements ermittelt werden.

Ein Fehlerschwellwert kann durch eine mathematische Vorschrift in eine Stromaufnahme überführt werden. Insbesondere kann diese mathematische Vorschrift durch eine Kalibrationskurve des Differenzstromsensors bestimmt werden. Alternativ oder zusätzlich kann diese mathematische Vorschrift durch Materialeigenschaften des magnetfeldempfindlichen Bauelements bestimmt werden. Wiederum alternativ oder zusätzlich kann diese mathematische Vorschrift durch ein Frequenzspektrum eines Referenzsignals bestimmt werden.

Insbesondere kann ein einer Amplitude zumindest einer Harmonischen des Frequenzspektrums des Signals entsprechender Analysewert, bevorzugt zumindest zwei Harmonischer und besonders bevorzugt zumindest drei Harmonischer, einem als Amplitude zumindest einer Harmonischen eines Frequenzspektrums eines Referenzsignals entsprechender Fehlerschwellwert zugeordnet werden, bevorzugt zumindest zwei Harmonischer und besonders bevorzugt zumindest drei Harmonischer.

Vorteilhaft kann ein einem Quadrat einer Amplitude zumindest einer Harmonischen des Frequenzspektrums des Signals entsprechender Analysewert, bevorzugt Quadraten von Amplituden zumindest zwei Harmonischer und besonders bevorzugt Quadraten von Amplituden zumindest drei Harmonischer, einem Quadrat einer Amplitude zumindest einer Harmonischen eines Frequenzspektrums eines Referenzsignals entsprechender Fehlerschwellwert zugeordnet werden, bevorzugt Quadraten von Amplituden zumindest zwei Harmonischer und besonders bevorzugt Quadraten von Amplituden zumindest drei Harmonischer.

Vorteilhaft kann ein einer Summe von Amplituden von zumindest zwei Harmonischen des Frequenzspektrums des Signals entsprechender Analysewert, bevorzugt einer Summe von Amplituden von zumindest drei Harmonischen des Frequenzspektrums des Signals und besonders bevorzugt einer Summe von Amplituden von zumindest vier oder mehr Harmonischen des Frequenzspektrums des Signals einem einer Summe von Amplituden von zumindest zwei Harmonischen eines Frequenzspektrums eines Referenzsignals entsprechenden Fehlerschwellwert zugeordnet werden, bevorzugt einer Summe von Amplituden von zumindest drei Harmonischen eines Frequenzspektrums eines Referenzsignals und besonders bevorzugt einer Summe von Amplituden von zumindest vier oder mehr Harmonischen eines Frequenzspektrums eines Referenzsignals.

Vorteilhaft kann ein einer Summe von Quadraten von Amplituden von zumindest zwei Harmonischen des Frequenzspektrums des Signals entsprechender Analysewert, bevorzugt einer Summe von Quadraten von Amplituden von zumindest drei Harmonischen des Frequenzspektrums des Signals und besonders bevorzugt einer Summe von Quadraten von Amplituden von zumindest vier oder mehr Harmonischen des Frequenzspektrums des Signals einem einer Summe von Quadraten von Amplituden von zumindest zwei Harmonischen eines Frequenzspektrums eines Referenzsignals entsprechenden Fehlerschwellwert zugeordnet werden, bevorzugt einer Summe von Quadraten von Amplituden von zumindest drei Harmonischen eines Frequenzspektrums eines Referenzsignals und besonders bevorzugt einer Summe von Quadraten von Amplituden von zumindest vier oder mehr Harmonischen eines Frequenzspektrums eines Referenzsignals.

Unter einem "Referenzsignal" kann ein an einer Hauptwicklung, insbesondere an einer ersten Hauptwicklung und/oder an einer zweiten Hauptwicklung messbares Signal bei einem definierten Zustand verstanden werden.

Das Referenzsignal kann als skalarer Wert ausgebildet sein. Alternativ oder zusätzlich kann das Referenzsignal als vektorieller Wert ausgebildet sein. Mit anderen Worten kann das Referenzsignal mehr als eine Größe umfassen. Insbesondere kann das Referenzsignal zwei, drei oder mehr Werte umfassen.

Vorzugsweise entspricht das Referenzsignal dem an einer ersten Hauptwicklung und/oder an einer zweiten Hauptwicklung messbaren Signal, wenn an den von dem Differenzstromsensor überwachten Leitern kein Fehlerstrom auftritt.

Vorteilhaft entspricht das Referenzsignal dem an einer ersten Hauptwicklung und/oder an einer zweiten Hauptwicklung messbaren Signal, wenn an den von dem Differenzstromsensor überwachten Leitern kein Strom fließt.

Vorteilhaft entspricht das Referenzsignal dem an einer ersten Hauptwicklung und/oder an einer zweiten Hauptwicklung messbaren Signal, wenn an den von dem Differenzstromsensor überwachten Leitern ein Strom fließt, insbesondere ein definierter Strom.

Abermals vorteilhaft entspricht das Referenzsignal dem an einer ersten Hauptwicklung und/oder an einer zweiten Hauptwicklung messbaren Signal, wenn das magnetfeldempfindliche Bauelement einen magnetischen Offset von größer oder gleich 2 % der Sättigungsflussdichte des magnetfeldempfindlichen Bauelements aufweist, vorzugsweise von größer oder gleich 5 % der Sättigungsflussdichte des magnetfeldempfindlichen Bauelements und besonders bevorzugt von größer oder gleich 8 % der Sättigungsflussdichte des magnetfeldempfindlichen Bauelements.

Zweckmäßig kann das Zustandsanalysemittel zur Bestimmung des Zustands dazu eingerichtet sein, zumindest ein Abschaltsignal bereitzustellen, wenn der Analysewert größer oder gleich dem korrespondierenden Fehlerschwellwert ist.

### Begrifflich sei hierzu Folgendes erläutert:

Unter einem "Abschaltsignal" wird ein Signal verstanden, welches dafür verwendet werden kann, einen durch einen Stromkreis fließenden Strom zu unterbrechen, insbesondere kann ein Abschaltsignal in einer Wirkverbindung zu einem Schaltelement dazu eingerichtet sein, dass ein durch einen Stromkreis fließender Strom unterbrochen wird.

Vorzugsweise kann durch ein Abschaltsignal ein durch die von einem designierten Differenzstromsensor überwachten Leiter fließender Strom unterbrochen werden.

Wenn der Analysewert größer oder gleich seinem korrespondierendem Fehlerschwellwert ist, fließt ein nicht zulässiger Fehlerstrom in dem von einem designierten Differenzstromsensor überwachten Stromkreis, sodass die ein Abschaltsignal bereitgestellt wird, damit der Stromfluss in dem Stromkreis unterbrochen werden kann.

Zweckmäßig kann das das Zustandsanalysemittel zur Bestimmung des Zustands derart eingerichtet sein, dass der Analysewert einer Amplitude zumindest einer Harmonischen des Frequenzspektrums des Signals entspricht, bevorzugt zumindest zwei Harmonischer und besonders bevorzugt zumindest drei Harmonischer, oder
einem Quadrat einer Amplitude zumindest einer Harmonischen des Frequenzspektrums des Signals entspricht, bevorzugt als Quadrate der Amplituden zumindest zwei Harmonischer und besonders bevorzugt als Quadrate der Amplituden zumindest drei Harmonischer, oder
einer Summe von Amplituden von zumindest zwei Harmonischen des Frequenzspektrums des Signals entspricht, bevorzugt einer Summe von Amplituden von zumindest drei Harmonischen des Frequenzspektrums des Signals und besonders bevorzugt einer Summe von Amplituden von zumindest vier oder mehr Harmonischen des Frequenzspektrums des Signals,
   oder
einer Summe von Quadraten von Amplituden von zumindest zwei Harmonischen des Frequenzspektrums des Signals entspricht, bevorzugt einer Summe von Quadraten von Amplituden von zumindest drei Harmonischen des Frequenzspektrums des Signals und besonders bevorzugt einer Summe von Quadraten von Amplituden von zumindest vier oder mehr Harmonischen des Frequenzspektrums des Signals, und/oder
einer Anzahl von Frequenzen des Frequenzspektrums des Signals entspricht, wobei das Frequenzspektrum bis zum Erreichen eines Abbruchkriteriums bestimmt wird, wobei das Abbruchkriterium einer Abweichung zwischen dem Signal und einem aus dem Frequenzspektrum des Signals zurückgeführten Signal entspricht.

### Begrifflich sei hierzu Folgendes erläutert:

Unter einer "Harmonischen" wird eine harmonische Schwingung eines Signals, deren Frequenz ein ganzzahliges Vielfaches einer Grundfrequenz dieses Signals ist verstanden.

Unter einer "Grundfrequenz" kann die niedrigste Frequenz einer harmonischen Schwingung eines Signals verstanden werden, insbesondere eines Signals aufweisend mehr als eine Frequenz. In einem Frequenzspektrum eines Signals kann die Grundfrequenz die erste Frequenz des Signals sein.

Unter einem "Abbruchkriterium" wird ein Kriterium zum Abbruch einer Fourier-Transformation eines Signals verstanden.

Mit einer Fourier-Transformation können Signale, insbesondere aperiodische Signale in ein Frequenzspektrum überführt werden. Dabei können computergestützte Verfahren zum Einsatz kommen bei dem das Frequenzspektrum eines Signals bis zu einer definierten Abweichung zwischen dem ursprünglichen, zeitaufgelösten Signal und einem aus dem Frequenzspektrum dieses Signals in den Zeitbereich zurückgeführten Signals. Damit kann vorteilhaft die benötigte Rechenzeit für die Fourier-Transformation verkürzt werden und gleichzeitig die entstehende Abweichung transparent gemacht werden.

Unter einer "Abweichung" zwischen einem ursprünglichen, zeitaufgelösten Signal und einem aus dem Frequenzspektrum dieses Signals in den Zeitbereich zurückgeführten Signals kann der Unterschied zwischen den zeitlichen Verläufen dieser Signale verstanden werden.

Insbesondere kann eine Abweichung dem Unterschied zwischen einem ursprünglichen, zeitaufgelösten Signal und einem aus dem Frequenzspektrum dieses Signals in den Zeitbereich zurückgeführten Signals für einen definierten Betrachtungsbereich entsprechen. Der Betrachtungsbereich kann eine definierte Dauer, insbesondere die Periodendauer der Hauptschwingung dieses Signals sein. Mit anderen Worten kann der Betrachtungsbereich dem Kehrwert der Grundfrequenz des Signals entsprechen. Alternativ kann der Betrachtungsbereich jeder anderen beliebigen, definierten Dauer entsprechen. Vorzugsweise kann der Betrachtungsbereich von einem beliebigen Zeitpunkt an starten.

Der Unterschied zwischen einem ursprünglichen, zeitaufgelösten Signal und einem aus dem Frequenzspektrum dieses Signals in den Zeitbereich zurückgeführten Signals für einen definierten Betrachtungsbereich kann durch die Least-Squares-Methode bestimmt werden.

Unter einem "aus dem Frequenzspektrum des Signals zurückgeführten Signal" kann ein Signal verstanden werden, welches aus einem Frequenzspektrum eines zeitaufgelösten Signals wieder zurück in den Zeitbereich übertragen wird.

Vorteilhaft kann der Analysewert einer Amplitude einer Harmonischen 1. oder höherer Ordnung des Frequenzspektrums entsprechen, insbesondere einer Harmonischen 5. oder höherer Ordnung des Frequenzspektrums, vorzugsweise einer Harmonischen 10. oder höherer Ordnung des Frequenzspektrums und besonders bevorzugt einer Harmonischen 15. oder höherer Ordnung des Frequenzspektrums. Die Änderungen der Amplituden innerhalb des Frequenzspektrums eines an der Hauptwicklung messbaren Signals sind insbesondere im Bereich von Frequenzen höherer Ordnung stärker ausgeprägt. Dadurch kann die die Sensitivität des Differenzstromsensors insbesondere gegenüber kleinen Fehlerströmen erhöht werden.

Vorteilhaft kann der Analysewert einem Quadrat einer Amplitude einer Harmonischen 1. oder höherer Ordnung des Frequenzspektrums entsprechen, insbesondere einem Quadrat einer Harmonischen 5. oder höherer Ordnung des Frequenzspektrums, vorzugsweise einem Quadrat einer Harmonischen 10. oder höherer Ordnung des Frequenzspektrums und besonders bevorzugt einem Quadrat einer Harmonischen 15. oder höherer Ordnung des Frequenzspektrums. Dadurch kann die die Sensitivität des Differenzstromsensors insbesondere gegenüber kleinen Fehlerströmen nochmals erhöht werden.

Vorteilhaft kann der Analysewert einer Summe von zumindest zwei Amplituden von Harmonischen 1. oder höherer Ordnung des Frequenzspektrums entsprechen, insbesondere einer Summe von zumindest zwei Amplituden von Harmonischen 5. oder höherer Ordnung des Frequenzspektrums, vorzugsweise einer Summe von zumindest zwei Amplituden von Harmonischen 10. oder höherer Ordnung des Frequenzspektrums und einer Summe von zumindest zwei Amplituden von Harmonischen 15. oder höherer Ordnung des Frequenzspektrums. Dadurch kann die die Sensitivität des Differenzstromsensors insbesondere gegenüber kleinen Fehlerströmen abermals erhöht werden.

Vorteilhaft kann der Analysewert einer Summe von Quadraten von zumindest zwei Amplituden von Harmonischen 1. oder höherer Ordnung des Frequenzspektrums entsprechen, insbesondere einer Summe von Quadraten von zumindest zwei Amplituden von Harmonischen 5. oder höherer Ordnung des Frequenzspektrums, vorzugsweise einer Summe von Quadraten von zumindest zwei Amplituden von Harmonischen 10. oder höherer Ordnung des Frequenzspektrums und einer Summe von Quadraten von zumindest zwei Amplituden von Harmonischen 15. oder höherer Ordnung des Frequenzspektrums. Dadurch kann die die Sensitivität des Differenzstromsensors insbesondere gegenüber kleinen Fehlerströmen erneut abermals erhöht werden.

Zweckmäßig kann das Zustandsanalysemittel zur Bestimmung des Zustands derart eingerichtet sein, dass der korrespondierende Fehlerschwellwert einem Gleichstromfehlerschwellwert und/oder einem Wechselstromfehlerschwellwert entspricht.

### Begrifflich sei hierzu Folgendes erläutert:

Unter einem "Gleichstromfehlerschwellwert" wird ein Fehlerschwellwert verstanden, der in einen zugehörigen pulsierenden Gleichstromfehler und/oder in einen glatten Gleichstromfehler überführt werden kann, insbesondere durch eine mathematische Vorschrift, bevorzugt durch eine mathematische Vorschrift durch eine Kalibrationskurve des Differenzstromsensors. Mit anderen Worten kann eine Gleichstromfehlerschwellwert einem Fehlerschwellwert für pulsierende Gleichstromfehler und/oder glatte Gleichstromfehler entsprechen.

Ein glatter Gleichstromfehler kann auch als Vormagnetisierung des magnetfeldempfindlichen Bauelements bezeichnet werden. Unter einem "Wechselstromfehlerschwellwert" wird ein Fehlerschwellwert verstanden, der in einen zugehörigen Wechselstromfehler überführt werden kann, insbesondere durch eine mathematische Vorschrift, bevorzugt durch eine mathematische Vorschrift durch eine Kalibrationskurve des Differenzstromsensors. Mit anderen Worten kann Wechselstromfehlerschwellwert einem Fehlerschwellwert für Wechselstromfehler entsprechen.

Die Analysevorrichtung kann zum Entmagnetisieren des magnetfeldempfindlichen Bauelements eingerichtet sein.

Alternativ kann die Analysevorrichtung zum Entmagnetisieren des magnetfeldempfindlichen Bauelements eingerichtet sein.

Vorteilhaft kann hierdurch erreicht werden, dass mittels der Analysevorrichtung zunächst erkannt werden kann, ob das magnetfeldempfindliche Bauelement vormagnetisiert ist und sofern eine Vormagnetisierung besteht diese wieder zurückgeführt werden kann. Hierdurch kann einerseits die Genauigkeit eines Differenzstromsensors wieder verbessert werden und andererseits die Robustheit eines Differenzstromsensors hinsichtlich der Genauigkeit der Messdaten erhöht werden.

Die Analysevorrichtung kann zum teilweisen Entmagnetisieren des magnetfeldempfindlichen Bauelements eingerichtet sein, insbesondere zum vollständigen Entmagnetisieren des magnetfeldempfindlichen Bauelements.

Die Analysevorrichtung kann zum Entmagnetisieren des magnetfeldempfindlichen Bauelements durch ein äußeres Magnetfeld eingerichtet, insbesondere durch ein durch eine Wicklung fließenden Strom hervorgerufenes äußeres Magnetfeld, bevorzugt durch ein durch die Hauptwicklung fließenden Strom hervorgerufenes äußeres Magnetfeld.

Nach einem ersten Aspekt der Erfindung löst die Aufgabe ein Differenzstromsensor zum allstromsensitiven Bestimmen eines elektrischen Differenzstroms gemäß Anspruch 1.

Das magnetfeldempfindliche Bauelement weist eine nanokristalline Struktur auf.

### Begrifflich sei hierzu Folgendes erläutert:

Unter einem Material mit einer "nanokristallinen Struktur" wird ein polykristalliner Festkörper mit einer Nano-Mikrostruktur verstanden, wobei unter der Mikrostruktur die Art, die Kristallstruktur, die Anzahl, die Form und die topologische Anordnung von Punktdefekten, Versetzungen, Stapelfehlern und Korngrenzen in einem kristallinen Material verstanden wird.

Durch die nanokristalline Struktur lassen sich die physikalischen Eigenschaften des Differenzstromsensors weiter verbessern. Insbesondere kann die Permeabilität des weichmagnetischen Stoffes erhöht werden.

Vorzugsweise wird ein nanokristallines Material aus einem amorphen Material hergestellt, wobei das Kristallwachstum ausgehend von dem amorphen Material durch Einwirkung einer thermischen und/oder magnetischen Einwirkung angeregt wird.

Vorteilhaft kann hierdurch die Sensitivität des Differenzstromsensors verbessert werden.

Gemäß einer bevorzugten Ausführungsform weist das magnetfeldempfindliche Bauelement folgende atomare Zusammensetzung auf:

[Fe₁₋ₐNiₐ]_{100-x-y-z-α-β-γ} CuₓSi_{y}B_{z}Nb_{α}M'_{β}M"_{γ}

mit a ≤ 0,3, 0, 6 ≤ x ≤ 1,5, 10 ≤ y ≤ 17, 5 ≤ z ≤ 14, 2 ≤ α ≤ 6, β ≤ 7, γ ≤ 8, wobei M' mindestens eines der Elemente V, Cr, Co, Al und Zn ist, wobei M" mindestens eines der Elemente C, Ge, P, Ga, Sb, In und Be ist.

Laborversuche haben ergeben, dass die vorstehende Spezifikation des weichmagnetischen Stoffes zu besonders vorteilhaften Materialeigenschaften für den hier vorgeschlagenen Differenzstromsensor führen.

Dabei kann durch die vorstehende stoffliche Spezifizierung insbesondere ein Differenzstromsensor mit einer besonders kleinen Koerzitivfeldstärke und/oder einer besonders hohen Sättigungsflussdichte erreicht werden.

Vorteilhaft kann das magnetfeldempfindliche Bauelement eine relative Permeabilität von größer oder gleich 10.000 aufweisen, bevorzugt eine relative Permeabilität von größer oder gleich 50.000 und besonders bevorzugt eine relative Permeabilität von größer oder gleich 110.000.

Das magnetfeldempfindliche Bauelement kann eine relative Permeabilität von größer oder gleich 25.000 aufweisen, vorzugsweise eine relative Permeabilität von größer oder gleich 75.000, bevorzugt eine relative Permeabilität von größer oder gleich 130.000 und besonders bevorzugt eine relative Permeabilität von größer oder gleich 150.000

Durch eine steigende relative Permeabilität erhöht sich die Sensitivität des magnetfeldempfindlichen Bauelements. Insbesondere die Sensitivität des magnetfeldempfindlichen Bauelements gegenüber wechselnden Magnetfeldern, insbesondere wechselnden äußeren Magnetfeldern. Dadurch werden geringe Änderungen der äußeren Magnetfelder deutlicher sichtbar, insbesondere Änderungen der äußeren Magnetfelder welche durch eine Wicklung hervorgerufen werden. Damit kann ein Fehlerstrom schneller und zuverlässiger erkannt werden.

Nach einem zweiten Aspekt der Erfindung löst die Aufgabe ein Analyseverfahren zur Zustandsanalyse eines allstromsensitiven Differenzstromsensors gemäß Anspruch 9.

Zweckmäßig kann das Verwenden des Zustandsanalysemittels zur Analyse des zumindest einen Zustands des allstromsensitiven Differenzstromsensors die nachfolgenden Schritte aufweisen:
- Überführen des messbaren Signals in ein Frequenzspektrum des Signals;
- Ermitteln von zumindest einem Analysewert aus dem Frequenzspektrum des Signals;
- Vergleichen des Analysewertes mit zumindest einem korrespondierenden Fehlerschwellwert; und
- Bestimmen von zumindest einem Zustand in Abhängigkeit des Vergleichs von dem Analysewert mit dem korrespondierenden Fehlerschwellwert, insbesondere zumindest zwei, drei, vier oder mehr Zustände.

Vorteilhaft kann hierdurch erreicht werden, dass im Unterschied zu der bislang bekannten eindimensionalen Auswertung von Sensorsignalen mehrdimensional ausgewertet werden kann. Dadurch, dass in einem Frequenzspektrum eines Signals die Amplitude in Abhängigkeit der Frequenz vorliegt, kann zumindest ein zusätzlicher Indikator für die Auswertung des Sensorsignals zu Analyse herangezogen werden. Vorteilhaft kann hierdurch erreicht werden, dass neben dem Vorliegen eines Differenzstroms parallel auch der Zustand des Kerns bewertet werden kann. Weiterhin kann bevorzugt erreicht werden, dass unterschiedliche Zustände eindeutig voneinander differenziert werden können. Insbesondere kann dadurch erreicht werden, dass wenn mehr als ein Zustand gleichzeitig vorliegt, die vorliegenden Zustände besser voneinander differenziert werden können, insbesondere trennschärfer voneinander differenziert werden können.

Zweckmäßig kann das Analyseverfahren den nachfolgenden Schritt aufweisen:
- Bereitstellen von zumindest einem Abschaltsignal, wenn der Analysewert größer oder gleich dem korrespondierenden Fehlerschwellwert ist.

Vorteilhaft kann dadurch eine Fehlerstromabschalteinrichtung, insbesondere eine Fehlerstromabschalteinrichtung aufweisend eine Analysevorrichtung und einen Differenzstromsensor nach dem ersten Aspekt der Erfindung bereits bei geringen Fehlerströmen schnell und genau einen Stromfluss in einem durch eine Fehlerstromabschalteinrichtung überwachten Stromkreis unterbrechen, insbesondere wenn ein Fehlerstrom fließt, insbesondere wenn ein Fehlerstrom fließt, der die zugelassenen Grenzen übersteigt.

Zweckmäßig kann der Fehlerschwellwert einem Gleichstromfehlerschwellwert und/oder einem Wechselfehlerstromschwellwert entsprechen.

Vorteilhaft kann dadurch eine Fehlerstromabschalteinrichtung, insbesondere eine Fehlerstromabschalteinrichtung aufweisend eine Analysevorrichtung und einen Differenzstromsensor nach dem ersten Aspekt der Erfindung einen Gleichstromfehler und/oder einen Wechselstromfehler verbessert getrennt erkennen und einen Stromfluss in einem durch eine Fehlerstromabschalteinrichtung überwachten Stromkreis unterbrechen, insbesondere wenn ein Gleichstromfehler und/oder ein Wechselstromfehler vorliegt, insbesondere wenn ein glatter Gleichstromfehler vorliegt.

Gemäß einer besonders bevorzugten Ausführungsform entmagnetisiert das Analyseverfahren ein magnetfeldempfindliches Bauelement aufweisend eine Vormagnetisierung.

Vorteilhaft kann hierdurch erreicht werden, dass mittels dem Analyseverfahren zunächst erkannt werden kann, ob das magnetfeldempfindliche Bauelement vormagnetisiert ist und sofern eine Vormagnetisierung besteht diese wieder zurückgeführt werden kann. Hierdurch kann einerseits die Genauigkeit eines Differenzstromsensors wieder verbessert werden und andererseits die Robustheit eines Differenzstromsensors hinsichtlich der Genauigkeit der Messdaten erhöht werden.

Das Analyseverfahren kann ein magnetfeldempfindliches Bauelement aufweisend eine Vormagnetisierung teilweise entmagnetisieren, insbesondere vollständig entmagnetisieren.

Das Analyseverfahren kann ein magnetfeldempfindliches Bauelement aufweisend eine Vormagnetisierung durch ein äußeres Magnetfeld entmagnetisieren, insbesondere durch ein durch eine erste Hauptwicklung und/oder zweite Hauptwicklung fließenden Strom hervorgerufenes äußeres Magnetfeld.

Nach einem dritten Aspekt der Erfindung löst die Aufgabe die Verwendung eines Differenzstromsensors nach dem ersten Aspekt der Erfindung in einem Stromversorgungssystem, bevorzugt in einem Gleichstrom-Stromversorgungssystem und besonders bevorzugt in einem Gleichstrom-Stromversorgungssystem zur Stromversorgung eines batterieelektrischen Speichers.

Ein Stromversorgungsystem kann als ein Ladegerät ausgebildet sein, insbesondere als ein Ladegerät für ein Fahrzeug aufweisend einen batterieelektrischen Speicher, bevorzugt für ein batterieelektrisches Fahrzeug (BEV), abermals bevorzugt für ein batterieelektrisches Nutzfahrzeug.

Alternativ kann ein Stromversorgungssystem zumindest einen Frequenzumrichter aufweisen.

Weitere Vorteile, Einzelheiten und Merkmale der Erfindung ergeben sich nachfolgend aus den erläuterten Ausführungsbeispielen. Dabei zeigen im Einzelnen:

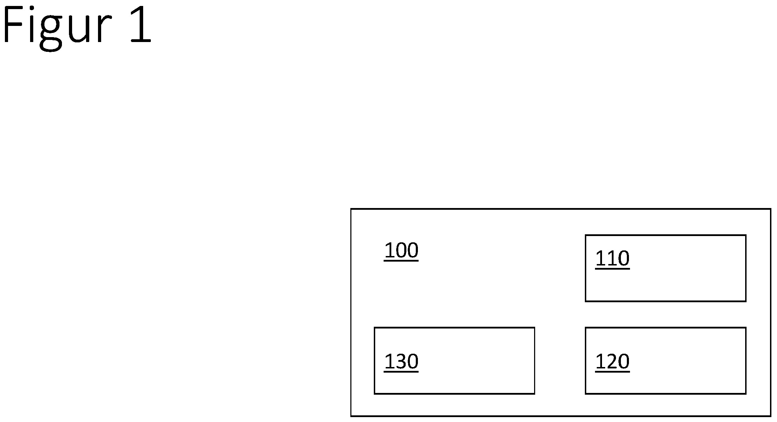

- Figur 1:: schematische Darstellung einer Analysevorrichtung,
- Figur 2:: schematische Darstellung eines Frequenzspektrums eines messbaren Signals einer Hauptwicklung, und
- Figur 3:: schematische Darstellung eines Frequenzspektrums eines weiteren messbaren Signals einer Hauptwicklung.

In der nun folgenden Beschreibung sind einzelne Merkmale, die in Zusammenhang mit einer Ausführungsform beschrieben wurden, auch separat in anderen Ausführungsformen verwendbar.

Die Analysevorrichtung 100 ist zur Zustandsanalyse eines allstromsensitiven Differenzstromsensors (nicht dargestellt) aufweisend ein magnetfeldempfindliches Bauelement (nicht dargestellt) und zumindest eine Hauptwicklung (nicht dargestellt) eingerichtet.

Der allstromsensitive Differenzstromsensor (nicht dargestellt) kann zumindest einen Zustand (nicht dargestellt) aufweisen, insbesondere zumindest zwei, drei, vier oder mehr Zustände.

Die Analysevorrichtung 100 weist ein Mittel zur Versorgung der Hauptwicklung mit einem elektrischen Strom 110 auf, wobei das Mittel zur Versorgung der Hauptwicklung mit einem elektrischen Strom 110 einen Oszillator (nicht dargestellt) aufweist, insbesondere einen analogen und/oder passiven Oszillator (nicht dargestellt), insbesondere einen Royer Oszillator (nicht dargestellt).

Die Analysevorrichtung 100 weist ein Mittel zur Bestimmung eines an der Hauptwicklung messbaren Signals 120 auf, insbesondere ein Mittel zur Bestimmung eines an der Hauptwicklung messbaren Signals 120, welches zur Bestimmung einer Stromaufnahme der Hauptwicklung (nicht dargestellt) eingerichtet ist.

Weiterhin weist die Analysevorrichtung 100 ein Zustandsanalysemittel 130 auf, welches dazu eingerichtet ist,
- dass an der Hauptwicklung (nicht dargestellt) messbare Signal (nicht dargestellt) in ein Frequenzspektrum (nicht dargestellt) des Signals zu überführen und/oder unter Verwendung eines Frequenzspektrums (nicht dargestellt) des Signals den zumindest einen Zustand (nicht dargestellt) zu bestimmen, insbesondere zumindest zwei, drei, vier oder mehr Zustände (nicht dargestellt),
   und/oder
- aus dem an der Hauptwicklung (nicht dargestellt) messbaren Signal (nicht dargestellt) zu bestimmen, ob das magnetfeldempfindliches Bauelement (nicht dargestellt) einen Vormagnetisierungszustand (nicht dargestellt) aufweist.

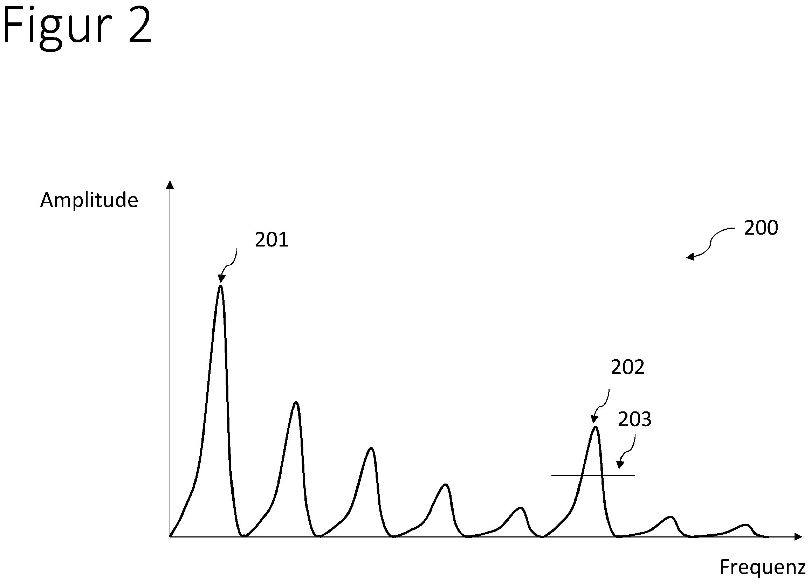

Figur 2 zeigt eine schematische Darstellung eines Frequenzspektrums eines an einer Hauptwicklung messbaren Signals einer Analysevorrichtung.

Das Frequenzspektrum des messbaren Signals (200) kann eine beliebige Anzahl an Harmonischen aufweisen. Die Amplitude der 1. Harmonischen (201) kann die Amplitude mit der größten Ausprägung sein. Wenn Fehlerströme an den von dem Differenzstromsensor überwachten Leitern fließen, wird zumindest eine Amplitude einer Harmonischen höherer Ordnung (202) in dem Frequenzspektrum des Signals stärker ausgeprägt. Mit anderen Worten kann der zumindest eine Analysewert einen höheren Wert annehmen. Wenn der Analysewert größer oder gleich einem korrespondierenden Fehlerschwellwert (203) ist, ist die Analysevorrichtung dazu eingerichtet, ein Abschaltsignal bereitzustellen.

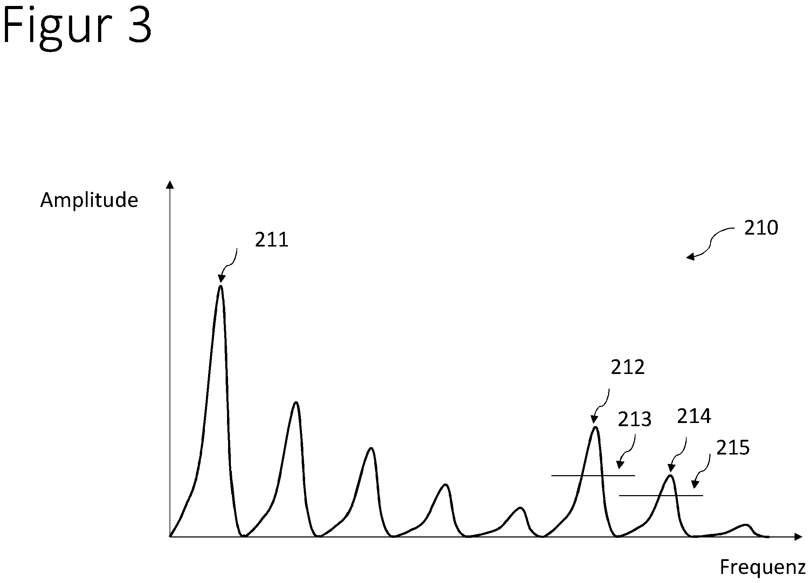

Figur 3 zeigt eine schematische Darstellung eines Frequenzspektrums eines an einer Hauptwicklung weiteren messbaren Signals einer Analysevorrichtung.

Das Frequenzspektrum des weiteren messbaren Signals (210) kann eine beliebige Anzahl an Harmonischen aufweisen. Die Amplitude der 1. Harmonischen (211) kann die Amplitude mit der größten Ausprägung sein. Wenn Fehlerströme an den von dem Differenzstromsensor überwachten Leitern fließen, werden Amplituden von Harmonischen höherer Ordnung (212, 214) in dem Frequenzspektrum des weiteren Signals stärker ausgeprägt. Mit anderen Worten kann der zumindest eine Analysewert zumindest einen höheren Wert annehmen, insbesondere zwei, drei oder mehr höhere Werte. Wenn der Analysewert größer oder gleich zumindest einem korrespondierenden Fehlerschwellwert (213, 215) ist, ist die Analysevorrichtung dazu eingerichtet, ein Abschaltsignal bereitzustellen.

### Bezugszeichenliste

- 100: Analysevorrichtung
- 110: Mittel zur Versorgung der Hauptwicklung mit einem elektrischen Strom
- 120: Mittel zur Bestimmung eines an der Hauptwicklung messbaren Signals
- 130: Zustandsanalysemittel
- 200: Frequenzspektrums eines messbaren Signals
- 201: Amplitude der 1. Harmonischen des Frequenzspektrums des Signals
- 202: Amplitude der 6. Harmonischen des Frequenzspektrums des Signals
- 203: Korrespondierender Fehlerschwellwert der Amplitude der 6. Harmonischen des Frequenzspektrums des Signals
- 210: Frequenzspektrums eines weiteren messbaren Signals
- 211: Amplitude der 1. Harmonischen des Frequenzspektrums des weiteren Signals
- 212: Amplitude der 6. Harmonischen des Frequenzspektrums des weiteren Signals
- 213: Korrespondierender Fehlerschwellwert der Amplitude der 6. Harmonischen des Frequenzspektrums des weiteren Signals
- 214: Amplitude der 7. Harmonischen des Frequenzspektrums des weiteren Signals
- 215: Korrespondierender Fehlerschwellwert der Amplitude der 7. Harmonischen des Frequenzspektrums des weiteren Signals

## Patentansprüche

1. Differenzstromsensor zum allstromsensitiven Bestimmen eines elektrischen Differenzstroms, wobei der Differenzstromsensor ein magnetfeldempfindliches Bauelement und zumindest eine Hauptwicklung aufweist, wobei der allstromsensitive Differenzstromsensor zumindest einen Zustand aufweisen kann, insbesondere zumindest zwei, drei, vier oder mehr Zustände, wobei der Differenzstromsensor eine Analysevorrichtung (100) zur Zustandsanalyse des allstromsensitiven Differenzstromsensors aufweist,
wobei die Analysevorrichtung (100) ein Mittel zur Versorgung der Hauptwicklung mit einem elektrischen Strom (110) aufweist, wobei das Mittel zur Versorgung der Hauptwicklung mit einem elektrischen Strom (110) einen Oszillator aufweist, insbesondere einen analogen und/oder passiven Oszillator, insbesondere einen Royer Oszillator,
wobei die Analysevorrichtung (100) ein Mittel zur Bestimmung eines an der Hauptwicklung messbaren Signals (120) aufweist, insbesondere ein Mittel zur Bestimmung eines an der Hauptwicklung messbaren Signals (120), welches zur Bestimmung einer Stromaufnahme der Hauptwicklung eingerichtet ist,
wobei die Analysevorrichtung (100) ein Zustandsanalysemittel (130) aufweist, welches dazu eingerichtet ist,
- dass an der Hauptwicklung messbare Signal in ein Frequenzspektrum des Signals zu überführen,
und/oder
- unter Verwendung eines Frequenzspektrums des Signals den zumindest einen Zustand zu bestimmen, insbesondere zumindest zwei, drei, vier oder mehr Zustände,
und/oder
- aus dem an der Hauptwicklung messbaren Signal zu bestimmen, ob das magnetfeldempfindliches Bauelement einen Vormagnetisierungszustand aufweist,
**dadurch gekennzeichnet, dass**
das magnetfeldempfindliche Bauelement eine nanokristalline Struktur aufweist.

2. Differenzstromsensor gemäß Anspruch 1, **dadurch gekennzeichnet, dass** das Zustandsanalysemittel (130) zur Bestimmung des Zustands dazu eingerichtet ist,
- zumindest einen Analysewert aus dem Frequenzspektrum des Signals zu bestimmen;
- den Analysewert mit zumindest einem korrespondierenden Fehlerschwellwert zu vergleichen; und
- zumindest einen Zustand in Abhängigkeit des Vergleichs von dem Analysewert mit dem korrespondierenden Fehlerschwellwert zu bestimmen, insbesondere zumindest zwei, drei, vier oder mehr Zustände.

3. Differenzstromsensor gemäß Anspruch 2, **dadurch gekennzeichnet, dass** das Zustandsanalysemittel (130) zur Bestimmung des Zustands dazu eingerichtet ist, zumindest ein Abschaltsignal bereitzustellen, wenn der Analysewert größer oder gleich dem korrespondierenden Fehlerschwellwert ist.

4. Differenzstromsensor gemäß einem der Ansprüche 2 bis 3, **dadurch gekennzeichnet, dass** das Zustandsanalysemittel (130) zur Bestimmung des Zustands derart eingerichtet ist, dass der Analysewert einer Amplitude zumindest einer Harmonischen des Frequenzspektrums des Signals entspricht, bevorzugt zumindest zwei Harmonischer und besonders bevorzugt zumindest drei Harmonischer,
oder
einem Quadrat einer Amplitude zumindest einer Harmonischen des Frequenzspektrums des Signals entspricht, bevorzugt als Quadrate von Amplituden zumindest zwei Harmonischer und besonders bevorzugt als Quadrate von Amplituden zumindest drei Harmonischer, oder
einer Summe von Amplituden von zumindest zwei Harmonischen des Frequenzspektrums des Signals entspricht, bevorzugt einer Summe von Amplituden von zumindest drei Harmonischen des Frequenzspektrums des Signals und besonders bevorzugt einer Summe von Amplituden von zumindest vier oder mehr Harmonischen des Frequenzspektrums des Signals,
oder
einer Summe von Quadraten von Amplituden von zumindest zwei Harmonischen des Frequenzspektrums des Signals entspricht, bevorzugt einer Summe von Quadraten von Amplituden von zumindest drei Harmonischen des Frequenzspektrums des Signals und besonders bevorzugt einer Summe von Quadraten von Amplituden von zumindest vier oder mehr Harmonischen des Frequenzspektrums des Signals, und/oder
einer Anzahl von Frequenzen des Frequenzspektrums des Signals entspricht, wobei das Frequenzspektrum bis zum Erreichen eines Abbruchkriteriums bestimmt wird, wobei das Abbruchkriterium einer Abweichung zwischen dem Signal und einem aus dem Frequenzspektrum des Signals zurückgeführten Signal entspricht.

5. Differenzstromsensor gemäß einem der Ansprüche 2 bis 4, **dadurch gekennzeichnet, dass** das Zustandsanalysemittel (130) zur Bestimmung des Zustands derart eingerichtet ist, dass der korrespondierende Fehlerschwellwert einem Gleichstromfehlerschwellwert und/oder einem Wechselstromfehlerschwellwert entspricht.

6. Differenzstromsensor gemäß einem der vorstehenden Ansprüche, **dadurch gekennzeichnet, dass** die Analysevorrichtung (100) zum Entmagnetisieren des magnetfeldempfindlichen Bauelements eingerichtet ist.

7. Differenzstromsensor gemäß einem der vorstehenden Ansprüche, **dadurch gekennzeichnet, dass** das magnetfeldempfindliche Bauelement folgende atomare Zusammensetzung aufweist:
[Fe₁₋ₐNiₐ]_{100-x-y-z-α-β-γ} CuₓSi_{y}B_{z}Nb_{α}M'_{β}M"_{γ}
mit a ≤ 0,3, 0, 6 ≤ x ≤ 1,5, 10 ≤ y ≤ 17, 5 ≤ z ≤ 14, 2 ≤ α ≤ 6, β ≤ 7, γ ≤ 8, wobei M' mindestens eines der Elemente V, Cr, Co, Al und Zn ist, wobei M" mindestens eines der Elemente C, Ge, P, Ga, Sb, In und Be ist.

8. Differenzstromsensor gemäß einem der vorstehenden Ansprüche, **dadurch gekennzeichnet, dass** das magnetfeldempfindliche Bauelement eine relative Permeabilität von größer oder gleich 10.000 aufweist, bevorzugt eine relative Permeabilität von größer oder gleich 50.000 und besonders bevorzugt eine relative Permeabilität von größer oder gleich 110.000.

9. Analyseverfahren zur Zustandsanalyse eines allstromsensitiven Differenzstromsensors, wobei das Analyseverfahren zur Verwendung eines Differenzstromsensors gemäß einem der Ansprüche 1 bis 8 eingerichtet ist und wobei das Analyseverfahren die nachfolgenden Schritte aufweist:
- Erfassen eines an der Hauptwicklung des allstromsensitiven Differenzstromsensors messbaren Signals; und
- Verwenden eines Zustandsanalysemittels zur Analyse des zumindest einen Zustands des allstromsensitiven Differenzstromsensors.

10. Analyseverfahren zur Zustandsanalyse eines allstromsensitiven Differenzstromsensors nach Anspruch 9, wobei das Verwenden des Zustandsanalysemittels zur Analyse des zumindest einen Zustands des allstromsensitiven Differenzstromsensors die nachfolgenden Schritte aufweist:
- Überführen des messbaren Signals in ein Frequenzspektrum des Signals;
- Ermitteln von zumindest einem Analysewert aus dem Frequenzspektrum des Signals;
- Vergleichen des Analysewertes mit zumindest einem korrespondierenden Fehlerschwellwert; und
- Bestimmen von zumindest einem Zustand in Abhängigkeit des Vergleichs von dem Analysewert mit dem korrespondierenden Fehlerschwellwert, insbesondere zumindest zwei, drei, vier oder mehr Zustände.

11. Analyseverfahren zur Zustandsanalyse eines allstromsensitiven Differenzstromsensors nach Anspruch 10, aufweisend den nachfolgenden Schritt:
- Bereitstellen von zumindest einem Abschaltsignal, wenn der Analysewert größer oder gleich dem korrespondierenden Fehlerschwellwert ist.

12. Analyseverfahren gemäß einem der Ansprüche 9 bis 11, **dadurch gekennzeichnet, dass** das Analyseverfahren ein magnetfeldempfindliches Bauelement aufweisend eine Vormagnetisierung entmagnetisiert.

13. Verwendung eines Differenzstromsensors nach einem der Ansprüche 1 bis 8 in einem Stromversorgungsystem, bevorzugt in einem Gleichstrom-Stromversorgungssystem und besonders bevorzugt in einem Gleichstrom-Stromversorgungssystem zur Stromversorgung eines batterieelektrischen Speichers.

## Claims

1. Differential current sensor for the AC/DC-sensitive determination of an electrical differential current, the differential current sensor having a magnetic-field-sensitive component and at least one main winding, it being possible for the AC/DC-sensitive differential current sensor to have at least one state, in particular at least two, three, four or more states, the differential current sensor having an analysis device (100) for analyzing the state of the AC/DC-sensitive differential current sensor,
the analysis device (100) having a means for supplying the main winding with an electrical current (110), the means for supplying the main winding with an electrical current (110) having an oscillator, in particular an analog and/or passive oscillator, in particular a Royer oscillator,
the analysis device (100) having a means for determining a signal (120) that can be measured on the main winding, in particular a means for determining a signal (120) that can be measured on the main winding and is configured to determine a current consumption of the main winding,
the analysis device (100) having a state analysis means (130) which is designed to
- convert that signal that can be measured on the main winding into a frequency spectrum of the signal,
and/or
- using a frequency spectrum of the signal, to determine the at least one state, in particular at least two, three, four or more states,
and/or
- determine, from the signal that can be measured on the main winding, whether the magnetic-field-sensitive component has a pre-magnetization state,
**characterized in that**
the magnetic-field-sensitive component has a nanocrystalline structure.

2. Differential current sensor according to claim 1, **characterized in that** the state analysis means (130) for determining the state is configured to
- determine at least one analysis value from the frequency spectrum of the signal;
- compare the analysis value with at least one corresponding error threshold value; and
- determine at least one state on the basis of the comparison of the analysis value with the corresponding error threshold value, in particular at least two, three, four or more states.

3. Differential current sensor according to claim 2, **characterized in that** the state analysis means (130) for determining the state is configured to provide at least one switch-off signal when the analysis value is greater than or equal to the corresponding error threshold value.

4. Differential current sensor according to any of claims 2 to 3, **characterized in that** the state analysis means (130) for determining the state is configured such that the analysis value corresponds to an amplitude of at least one harmonic of the frequency spectrum of the signal, preferably at least two harmonics and particularly preferably at least three harmonics,
or
corresponds to a square of an amplitude of at least one harmonic of the frequency spectrum of the signal, preferably as squares of amplitudes of at least two harmonics and particularly preferably as squares of amplitudes of at least three harmonics, or
corresponds to a sum of amplitudes of at least two harmonics of the frequency spectrum of the signal, preferably to a sum of amplitudes of at least three harmonics of the frequency spectrum of the signal and particularly preferably to a sum of amplitudes of at least four or more harmonics of the frequency spectrum of the signal,
or
corresponds to a sum of squares of amplitudes of at least two harmonics of the frequency spectrum of the signal, preferably to a sum of squares of amplitudes of at least three harmonics of the frequency spectrum of the signal and particularly preferably to a sum of squares of amplitudes of at least four or more harmonics of the frequency spectrum of the signal,
and/or
corresponds to a number of frequencies of the frequency spectrum of the signal, the frequency spectrum being determined until a termination criterion is reached, the termination criterion corresponding to a deviation between the signal and a signal returned from the frequency spectrum of the signal.

5. Differential current sensor according to any of claims 2 to 4,
**characterized in that** the state analysis means (130) for determining the state is configured such that the corresponding error threshold value corresponds to a direct current error threshold value and/or to an alternating current error threshold value.

6. Differential current sensor according to any of the preceding claims, **characterized in that** the analysis device (100) is configured to demagnetize the magnetic-field-sensitive component.

7. Differential current sensor according to any of the preceding claims, **characterized in that** the magnetic-field-sensitive component has the following atomic composition:
[Fe₁₋ₐNiₐ]_{100-x-y-z-α-β-γ} CuₓSi_{y}BₓNb_{α}M'_{β}M"_{γ}
with a ≤ 0.3, 0.6 ≤ x ≤ 1.5, 10 ≤ y ≤ 17, 5 ≤ z ≤ 14, 2 ≤ α ≤ 6, β ≤ 7, γ ≤ 8, M' being at least one of the elements V, Cr, Co, Al and Zn, M" being at least one of the elements C, Ge, P, Ga, Sb, In and Be.

8. Differential current sensor according to any of the preceding claims, **characterized in that** the magnetic-field-sensitive component has a relative permeability of greater than or equal to 10,000, preferably a relative permeability of greater than or equal to 50,000 and particularly preferably a relative permeability of greater than or equal to 110,000.

9. Analysis method for analyzing the state of an AC/DC-sensitive differential current sensor, wherein the analysis method is configured to use a differential current sensor according to any of claims 1 to 8 and wherein the analysis method has the following steps:
- detecting a signal that can be measured on the main winding of the AC/DC-sensitive differential current sensor; and
- using a state analysis means for analyzing the at least one state of the AC/DC-sensitive differential current sensor.

10. Analysis method for analyzing the state of an AC/DC-sensitive differential current sensor according to claim 9, wherein the use of the state analysis means for analyzing the at least one state of the AC/DC-sensitive differential current sensor comprises the following steps:
- converting the measurable signal into a frequency spectrum of the signal;
- identifying at least one analysis value from the frequency spectrum of the signal;
- comparing the analysis value with at least one corresponding error threshold value; and
- determining at least one state on the basis of the comparison of the analysis value with the corresponding error threshold value, in particular at least two, three, four or more states.

11. Analysis method for analyzing the state of an AC/DC-sensitive differential current sensor according to claim 10, comprising the following step:
- providing at least one switch-off signal if the analysis value is greater than or equal to the corresponding error threshold value.

12. Analysis method according to any of claims 9 to 11, **characterized in that** the analysis method demagnetizes a magnetic-field-sensitive component having a pre-magnetization.

13. Use of a differential current sensor according to any of claims 1 to 8 in a power supply system, preferably in a direct current power supply system and particularly preferably in a direct current power supply system for supplying power to a battery electrical storage system.

## Revendications

1. Capteur de courant différentiel pour la détermination sensible à tous courants d'un courant différentiel électrique, le capteur de courant différentiel présentant un composant sensible au champ magnétique et au moins un enroulement principal, le capteur de courant différentiel sensible à tous courants pouvant présenter au moins un état, en particulier au moins deux, trois, quatre états ou plus, le capteur de courant différentiel présentant un dispositif d'analyse (100) pour l'analyse d'état du capteur de courant différentiel sensible à tous courants,
le dispositif d'analyse (100) présentant un moyen d'alimentation de l'enroulement principal avec un courant électrique (110), le moyen d'alimentation de l'enroulement principal avec un courant électrique (110) présentant un oscillateur, en particulier un oscillateur analogique et/ou passif, en particulier un oscillateur Royer,
le dispositif d'analyse (100) présentant un moyen de détermination d'un signal mesurable (120) au niveau de l'enroulement principal, en particulier un moyen de détermination d'un signal mesurable (120) au niveau de l'enroulement principal, lequel est conçu pour la détermination d'une consommation de courant de l'enroulement principal,
le dispositif d'analyse (100) présentant un moyen d'analyse d'état (130), lequel est conçu pour
- transformer le signal mesurable au niveau de l'enroulement principal en un spectre de fréquence du signal,
et/ou
- en utilisant un spectre de fréquence du signal, déterminer l'au moins un état, en particulier au moins deux, trois, quatre états ou plus,
et/ou
- à partir du signal mesurable au niveau de l'enroulement principal, déterminer si le composant sensible au champ magnétique présente un état de prémagnétisation,
**caractérisé en ce que**
le composant sensible au champ magnétique présente une structure nanocristalline.

2. Capteur de courant différentiel selon la revendication 1,
**caractérisé en ce que** le moyen d'analyse d'état (130) est, pour la détermination de l'état, conçu pour
- déterminer au moins une valeur d'analyse à partir du spectre de fréquences du signal ;
- comparer la valeur d'analyse à au moins une valeur seuil d'erreur correspondante ; et
- déterminer au moins un état, en particulier au moins deux, trois, quatre états ou plus, en fonction de la comparaison de la valeur d'analyse à la valeur seuil d'erreur correspondante.

3. Capteur de courant différentiel selon la revendication 2,
**caractérisé en ce que** le moyen d'analyse d'état (130) est, pour la détermination de l'état, conçu pour fournir au moins un signal d'arrêt lorsque la valeur d'analyse est supérieure ou égale à la valeur seuil d'erreur correspondante.

4. Capteur de courant différentiel selon l'une des revendications 2 à 3, **caractérisé en ce que** le moyen d'analyse d'état (130) est, pour la détermination de l'état, conçu de telle façon que la valeur d'analyse correspond à une amplitude d'au moins une composante harmonique du spectre de fréquence du signal, de préférence d'au moins deux composantes harmoniques et encore plus préférablement d'au moins trois composantes harmoniques,
ou
correspond au carré d'une amplitude d'au moins une composante harmonique du spectre de fréquence du signal, de préférence en tant que carrés d'amplitudes d'au moins deux composantes harmoniques et encore plus préférablement en tant que carrés d'amplitudes d'au moins trois composantes harmoniques, ou
correspond à une somme d'amplitudes d'au moins deux composantes harmoniques du spectre de fréquence du signal, de préférence à une somme d'amplitudes d'au moins trois composantes harmoniques du spectre de fréquence du signal et encore plus préférablement à une somme d'amplitudes d'au moins quatre composantes harmoniques du spectre de fréquence du signal ou plus,
ou
correspond à une somme de carrés d'amplitudes d'au moins deux composantes harmoniques du spectre de fréquence du signal, de préférence à une somme de carrés d'amplitudes d'au moins trois composantes harmoniques du spectre de fréquence du signal et encore plus préférablement à une somme de carrés d'amplitudes d'au moins quatre composantes harmoniques du spectre de fréquence du signal ou plus,
et/ou
correspond à un nombre de fréquences du spectre de fréquence du signal, le spectre de fréquence étant déterminé jusqu'à l'atteinte d'un critère d'interruption, le critère d'interruption correspondant à un écart entre le signal et un signal récupéré à partir du spectre de fréquence du signal.

5. Capteur de courant différentiel selon l'une des revendications 2 à 4, **caractérisé en ce que** le moyen d'analyse d'état (130) est, pour la détermination de l'état, conçu de telle façon que la valeur seuil d'erreur correspondante correspond à une valeur seuil d'erreur de courant continu et/ou à une valeur seuil d'erreur de courant alternatif.

6. Capteur de courant différentiel selon l'une des revendications précédentes, **caractérisé en ce que** le dispositif d'analyse (100) est conçu pour la démagnétisation du composant sensible au champ magnétique.

7. Capteur de courant différentiel selon l'une des revendications précédentes, **caractérisé en ce que** le composant sensible au champ magnétique présente la composition atomique suivante :
[Fe₁-ₐNiₐ]_{100-x-y-z-α-β- γ} CuₓSi_{y}B_{z}Nb_{α}M'_{β}M"_{γ}
avec a ≤ 0,3, 0,6 ≤ x ≤ 1,5, 10 ≤ y ≤ 17, 5 ≤ z ≤ 14, 2 ≤ α ≤ 6, β ≤ 7, γ ≤ 8, M' étant au moins un parmi les éléments V, Cr, Co, Al et Zn, M" étant au moins un parmi les éléments C, Ge, P, Ga, Sb, In et Be.

8. Capteur de courant différentiel selon l'une des revendications précédentes, **caractérisé en ce que** le composant sensible au champ magnétique présente une perméabilité relative supérieure ou égale à 10 000, de préférence une perméabilité relative supérieure ou égale à 50 000 et encore plus préférablement une perméabilité relative supérieure ou égale à 110 000.

9. Procédé d'analyse pour analyser l'état d'un capteur de courant différentiel sensible à tous courants, le procédé d'analyse étant conçu pour l'utilisation d'un capteur de courant différentiel selon l'une des revendications 1 à 8 et le procédé d'analyse présentant les étapes suivantes :
- détection d'un signal mesurable au niveau de l'enroulement principal du capteur de courant différentiel sensible à tous courants ; et
- utilisation d'un moyen d'analyse d'état pour l'analyse de l'au moins un état du capteur de courant différentiel sensible à tous courants.

10. Procédé d'analyse pour l'analyse d'état d'un capteur de courant différentiel sensible à tous courants selon la revendication 9, l'utilisation du moyen d'analyse d'état pour l'analyse de l'au moins un état du capteur de courant différentiel sensible à tous courants comprenant les étapes suivantes :
- transformation du signal mesurable en un spectre de fréquences du signal ;
- détermination d'au moins une valeur d'analyse à partir du spectre de fréquences du signal ;
- comparaison de la valeur d'analyse à au moins une valeur seuil d'erreur correspondante ; et
- détermination d'au moins un état, en particulier d'au moins deux, trois, quatre états ou plus, en fonction de la comparaison de la valeur d'analyse à la valeur seuil d'erreur correspondante.

11. Procédé d'analyse pour l'analyse d'état d'un capteur de courant différentiel sensible à tous courants selon la revendication 10, présentant l'étape suivante :
- fourniture d'au moins un signal d'arrêt, lorsque la valeur d'analyse est supérieure ou égale à la valeur seuil d'erreur correspondante.

12. Procédé d'analyse selon l'une des revendications 9 à 11,
**caractérisé en ce que** le procédé d'analyse démagnétise un composant sensible au champ magnétique présentant une prémagnétisation.

13. Utilisation d'un capteur de courant différentiel selon l'une des revendications 1 à 8 dans un système d'alimentation électrique, de préférence dans un système d'alimentation électrique en courant continu et encore plus préférablement dans un système d'alimentation électrique en courant continu pour l'alimentation électrique d'un accumulateur à batterie électrique.
